(19) Europäisches Patentamt
European Patent Office
Office européen des brevets

(11) **EP 2 275 994 B1**

(12) **FASCICULE DE BREVET EUROPEEN**

(45) Date de publication et mention de la délivrance du brevet:
**13.08.2014 Bulletin 2014/33**

(21) Numéro de dépôt: **10290317.6**

(22) Date de dépôt: **11.06.2010**

(51) Int Cl.:
*G06T 17/20* *(2006.01)*  *G09B 23/40* *(2006.01)*

(54) **Méthode pour générer un maillage hexa-dominant d'un milieu souterrain faillé**

Methode zur Erstellung eines hexa-dominanten Netzwerks eines verworfenen unterirdischen Milieus

Method for generating a hex-dominant mesh of an underground environment with faults

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **16.07.2009 FR 0903501**

(43) Date de publication de la demande:
**19.01.2011 Bulletin 2011/03**

(73) Titulaire: **IFP Energies nouvelles**
**92852 Rueil-Malmaison Cedex (FR)**

(72) Inventeurs:
• **Ran, Longmin**
**92500 Rueil-Malmaison (FR)**
• **Benali, Abdallah**
**92150 Suresnes (FR)**
• **Borouchaki, Houman**
**75015 Paris (FR)**
• **Bennis, Chakib**
**92500 Rueil-Malmaison (FR)**

(56) Documents cités:
**EP-A2- 0 801 364   FR-A1- 2 802 324**
**US-A- 5 740 342**

• **HEINEMANN Z E ET AL: "Modeling heavily faulted reservoirs", PROCEEDINGS / SPE SYMPOSIUM ON RESERVOIR SIMULATION, 14 - 17 FEBRUARY 1999, HOUSTON, TX,, 14 février 1999 (1999-02-14), pages 9-19, XP009129119,**
• **GRATIER JEAN-PIERRE ET AL: "Compatibility constraints on folded and faulted strata and calculation of total displacement using computational restoration (UNFOLD program)", JOURNAL OF STRUCTURAL GEOLOGY, PERGAMON PRESS, XX LNKD- DOI: 10.1016/0191-8141(93)90135-W, vol. 15, no. 3-5, 1 mars 1991 (1991-03-01) , pages 391-402, XP009133429, ISSN: 0191-8141**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

## Description

La présente invention concerne le domaine de l'exploration pétrolière, et plus particulièrement l'étude des écoulements de fluides au sein d'une formation souterraine.

La méthode s'applique notamment à l'étude des déplacements de fluides tels que des hydrocarbures dans un gisement, ou réservoir souterrain, traversé par des failles. Ces études sont réalisées dans le cadre de modélisation de bassin, de simulation de réservoir, et/ou de simulations d'injection de $CO_2$ dans une formation souterraine.

La modélisation de bassin vise à reconstruire l'histoire géologique d'un bassin sédimentaire et de ses systèmes pétroliers pour aider à localiser les pièges à hydrocarbures, c'est-à-dire les réservoirs, à estimer leur quantité et qualité, et enfin, à évaluer les risques de rencontrer des excès de pression pendant les forages. La simulation de réservoir étudie l'évolution au cours du temps des proportions d'eau, de gaz et de pétrole dans le réservoir afin de juger de la rentabilité, de valider ou d'optimiser la position des puits assurant le fonctionnement de l'exploitation du réservoir. Dans une époque où le développement durable et la protection d'environnement deviennent primordiaux, une troisième étude importante liée à l'exploration pétrolière est d'effectuer des simulations pour injecter du $CO_2$ dans le milieu poreux.

La modélisation de bassin, la simulation de réservoir et la simulation de $CO_2$ sont des techniques basées sur la simulation d'écoulement dans un milieu poreux. Ces simulations sont réalisées au moyen d'un système d'équations aux dérivées partielles par des méthodes de volumes finis sur un maillage décrivant la géométrie du milieu souterrain concerné. Aujourd'hui, l'exploration s'intéresse aux zones à géométrie complexe où les failles sont nombreuses et leurs positions aléatoires. La construction automatique d'un maillage 3D capable de représenter cette complexité géométrique est la première étape indispensable à l'élaboration du logiciel de simulation, le simulateur d'écoulement, pour un tel milieu, à partir des horizons qui délimitent les différentes couches géologiques, et des failles qui coupent les horizons. Les horizons et les failles sont fournis en tant que surfaces, triangulées à partir d'un semis de points. Ces points résultent généralement de sondages sismiques. Compte tenu des simulateurs d'écoulement utilisés dans l'industrie, il est nécessaire que le maillage comprenne le plus d'éléments hexaédriques possible pour permettre un meilleur résultat de la simulation ; et il faut mailler entre les horizons pour bien respecter l'infrastructure du milieu.

## État de la technique

Dans le monde de l'exploration pétrolière, la plupart des simulateurs d'écoulement du milieu poreux actuels travaille sur des grilles régulières ou « Scottish cartésiennes ». Pour essayer d'adapter les maillages aux failles et à toutes formes d'hétérogénéités, en tant que support du calcul de la simulation, on connaît la technique du raffinement local des grilles, la technique des grilles CPG (décrits dans le document FR 2 747 490 par exemple), ou encore, la technique des grilles avec des noeuds dédoublés verticalement.

Les maillages décrits ci-dessus sont basés sur des grilles. Ils sont quasiment structurés, c'est-à-dire que leur topologie est fixe : chaque sommet interne est incident à un nombre fixé de mailles et chaque maille est délimitée par un nombre fixé de faces et d'arêtes. Ils ne sont ainsi adaptés qu'à une géométrie relativement simple. Pour un simulateur de bassin, pour chaque âge donné, on construit un maillage par empilement des couches, représentées sur une même grille 2D (carte), reliées par des verticales. La construction du maillage est avantageusement très simple. Cependant, il est impossible de représenter des failles souvent obliques.

Pour pouvoir gérer les failles, il existe des méthodes qui effectuent d'abord une décomposition manuelle par blocs suivant les failles, puis génèrent un maillage simple pour chaque bloc. Cette approche n'est pourtant pas totalement adaptée à la simulation d'écoulement dans un milieu à géométrie complexe pour deux raisons : premièrement, la qualité d'éléments n'est pas satisfaisante pour des géométries irrégulières ; deuxièmement, avec la présence nombreuse et aléatoire des failles, il est presque impossible d'effectuer la décomposition manuelle du milieu traité.

Pour bien capter toute la complexité de la géométrie du milieu, il est aussi possible de construire un maillage entièrement non structuré, avec une topologie complètement arbitraire : un sommet du maillage peut appartenir à un nombre quelconque de mailles et chaque maille peut posséder un nombre quelconque d'arêtes ou de faces. On peut citer par exemple les maillages du type PErpendicular BIssector (PEBI) ou Voronoï proposés dans :

Z.E. Heinemann, G.F. Heinemann et B.M. Tranta, "Modelling heavily faulted reservoirs.", Proceedings of SPE Annual Technical Conferences, pages 9-19, New Orlean, Louisiana, september 1998, SPE.

Z.E. Heinemann, et al. "Modelling heavily faulted reservoirs", Proceedings of SPE symposium on reservoir simulation, pages 9-19, 14 février 1999.

Quoiqu'ils décrivent bien les géométries complexes, les maillages non structurés sont très lourds à construire, à manipuler et à stocker, au contraire de ceux structurés. Pour réconcilier entre les avantages et les inconvénients, des approches dites "hybrides" ont été proposées qui utilisent les maillages non structurés uniquement dans les zones à géométrie complexe. Un exemple est décrit dans le brevet US 5 740 342A. Néanmoins, le recollage des maillages non structurés aux ceux structurés reste une tâche difficile.

Enfin, quatre grandes catégories de méthode existent pour générer d'une manière automatique des maillages hexa-dominant, elles sont :

- les méthodes d'octree/grille,

- les méthodes de plâtrage,

- les méthodes par bloc,

- les méthodes par balayage.

Le principe des méthodes octree/grille consiste à emballer le domaine à mailler dans une grille, et à subdiviser ce cube d'une façon récursive jusqu'à ce que la géométrie du domaine soit bien captée, c'est-à-dire jusqu'à ce que le critère de la taille des mailles, qui dépend essentiellement de la distance minimale des points du contour et des ressources disponibles, soit rempli. Des éléments tétraédriques ou hexaédriques sont alors créés à l'intersection des surfaces du domaine en suivant certains motifs d'intersections.

Les méthodes d'octree/grille sont avantageusement automatisées et applicables quelle soit la géométrie. Pourtant, le maillage généré n'est pas conforme à la forme du domaine ; de plus, lorsque le contour est irrégulier, un calcul intense d'intersections est inévitable et une explosion du nombre de mailles peut se produire pour atteindre une bonne précision d'approximation des frontières.

Les méthodes de type plâtrage consistent à remplir le volume du domaine avec des éléments 3D à partir du front surfacique initial du modèle, et en avançant vers le centre en repartant du nouveau front qui vient d'être construit. La procédure se termine une fois que le front devient vide.

Dans les algorithmes de plâtrage, il est difficile de déterminer les ordres d'avancée du front et de détecter et traiter les zones de collision et de divergence. Ces méthodes sont ainsi considérées comme non robustes ; surtout quand les géométries complexes sont concernées, l'obtention d'un maillage de bonne qualité n'est pas garantie.

Les approches par blocs consistent à décomposer le domaine concerné en blocs grossiers ayant une topologie élémentaire (triangle, quadrangle, tétraèdre, pentaèdre, et hexaèdre), puis à mailler chaque bloc indépendamment les uns les autres par des méthodes algébriques ou par résolution d'EDP (équations aux dérivées partielles), et à recoller à la fin les blocs pour former le maillage global du domaine entier.

Le grand avantage des méthodes de blocs est qu'il est trivial de mailler une fois que la partition est achevée ; de plus, il est possible de résoudre le problème en parallèle sur chaque bloc. Toutefois, la partition elle-même reste très lourde et difficilement automatisable, et l'interfaçage inter-blocs doit être soigneusement géré pour assurer la conformité du recollement final.

Parfois considérées comme maillage 2.5D, les méthodes par balayage « balaient » un maillage quadrilatéral en suivant une courbe. Des couches régulières d'hexaèdres sont formées à un intervalle spécifié utilisant la même topologie que le maillage quadrilatéral. Cette technique peut être généralisée pour mailler des volumes de certaines classes par définition des surfaces de source et de cible.

Les maillages générés par les méthodes de balayage sont automatiquement alignés sur les interfaces, ce qui est évidemment un grand avantage. Pourtant, ces méthodes ne sont pas bien adaptées dans le contexte de la simulation du milieu poreux, où le changement topologique peut parvenir d'une surface horizon à une autre à cause de l'intervention des failles.

L'objet de l'invention concerne une méthode pour générer un maillage tridimensionnel d'un milieu souterrain, prenant en compte les déformations induites par les failles du milieu, et en s'affranchissant des problèmes précédemment mentionnés. La méthode y parvient en construisant des quadrillages réguliers pour chaque horizons géologiques, puis en les déformant conformément aux failles du milieu, puis en réalisant une correspondance entre chaque quadrillage, de façon à construire un maillage contenant un maximum de mailles hexaédriques.

**La méthode selon l'invention**

L'invention concerne une méthode pour générer un maillage d'un milieu souterrain comprenant au moins une couche sédimentaire traversée par au moins une faille, la couche étant délimitée verticalement par deux horizons géologiques discrétisés par deux surfaces tridimensionnelles triangulées. La méthode comporte les étapes suivantes :

- on transforme chaque surface tridimensionnelle triangulée en une surface bidimensionnelle triangulée sur laquelle on projette ladite faille, au moyen d'une technique de dépliage isométrique, la faille ainsi projetée formant des segments décrivant une courbe ouverte ;

- on génère un quadrillage bidimensionnel régulier pour chaque surface bidimensionnelle triangulée ;

- on déforme ledit quadrillage bidimensionnel régulier en déterminant une première arrête dudit quadrillage intersectée par ladite courbe ouverte, en parcourant ladite courbe segment par segment et en partant d'une extrémité de ladite courbe ouverte ; puis en déplaçant l'extrémité de l'arête intersectée la plus proche du point d'intersection vers ledit point d'intersection ;

- on effectue un changement de repère pour transformer ledit quadrillage régulier ainsi déformé en une surface quadrillée tridimensionnelle, et on transforme en deux triangles chaque quadrilatère traversé par ladite faille au niveau d'une diagonale ;

- on réitère les étapes précédentes pour la seconde surface tridimensionnelle triangulée en conservant un même nombre de quadrilatère dans chaque direction ;

- on génère ledit maillage du milieu souterrain en créant des liaisons entre chaque noeud de chaque quadrilatère et de chaque triangle des deux surfaces quadrillées tridimensionnelles, et en découpant chaque maille dudit maillage du milieu souterrain traversée par ladite faille.

Selon l'invention, si le milieu comporte plus d'une couche sédimentaire, on peut construire le maillage en réitérant couche par couche.
On peut générer le quadrillage régulier au moyen des étapes suivantes :

- on choisit quatre points sur la bordure de la surface 2D, définissant quatre courbes sur la bordure ;

- on choisit les dimensions du quadrillage (N, M), et l'on discrétise alternativement chacune des quatre courbes en fonction desdites dimensions;

- on applique la formule de Coons pour construire le quadrillage.

Selon un mode de réalisation, avant de déplacer l'extrémité la plus proche, on vérifie que ce déplacement n'engendre pas un quadrilatère dont au moins un angle est supérieur à un seuil d'angle fixé, si c'est le cas, on déplace l'autre extrémité de l'arrête intersectée.
Si le milieu comporte plusieurs failles, on peut prendre en compte les failles au sein dudit quadrillage régulier, en réalisant les étapes suivantes :

- on détermine une première arête dudit quadrillage intersectée par ladite courbe ouverte, en parcourant ladite courbe segment par segment et en partant d'une extrémité de ladite courbe ouverte ;

- on déplace l'extrémité de l'arête la plus proche du point d'intersection vers ledit point d'intersection si ce déplacement n'engendre pas un quadrilatère dont au moins un angle est supérieur à un seuil d'angle fixé, et si cette extrémité n'a pas déjà été déplacée ; sinon

- on déplace l'autre extrémité vers ledit point d'intersection si cette extrémité n'a pas déjà été déplacée ; sinon

- on raffine le maillage, jusqu'à ce qu'une extrémité puisse être déplacée, et on déplace cette extrémité.

Selon l'invention, pour raffiner le maillage on peut utiliser les étapes suivantes :

- on ajoute un nouveau noeud au maillage, correspondant à un point d'intersection entre une faille et l'arête pour laquelle aucune extrémité ne peut être déplacée ;

- si l'arête est verticale, on dédouble la ligne complète du quadrillage contenant le point d'intersection, en ajoutant une succession d'arêtes horizontales, dans tous les quadrilatères de la ligne, la succession d'arêtes passant par le point d'intersection ;

- si l'arête est horizontale, on dédouble la colonne complète du quadrillage contenant le point d'intersection, en ajoutant une succession d'arêtes verticales, dans tous les quadrilatères de la colonne, la succession d'arêtes passant par le point d'intersection.

On peut transformer le quadrillage régulier en une surface quadrillée à trois dimensions en réalisant les étapes suivantes :

- pour chaque noeud non situé sur une faille, on détermine ses coordonnées à partir de coordonnées barycentriques du noeud dans un repère défini par un triangle de la surface triangulée 2D auquel il appartient ;

- pour chaque noeud situé sur une faille, on détermine ses coordonnées à partir d'abscisses curvilignes mesurées sur ladite faille ;

- on établit des connectivités entre les noeuds de façon à maximiser un nombre de quadrilatère, seuls des quadrilatères pour lesquels une faille passe par l'une de ses diagonales, sont divisés en deux triangles.

Enfin, on peut créer des liaisons entre les noeuds en reliant chaque noeud de chaque surface quadrillée tridimensionnelle ayant des mêmes coordonnées i, j, et si une faille intersecte cette liaison, on relie un noeud avec ladite faille en considérant une direction d'un noeud voisin.

D'autres caractéristiques et avantages de la méthode selon l'invention, apparaîtront à la lecture de la description ci-après d'exemples non limitatifs de réalisations, en se référant aux figures annexées et décrites ci-après.

**Présentation succincte des figures**

- la figure 1 montre la détection d'un quadrilatère dégénéré

- la figure 4 montre le principe du raffinement

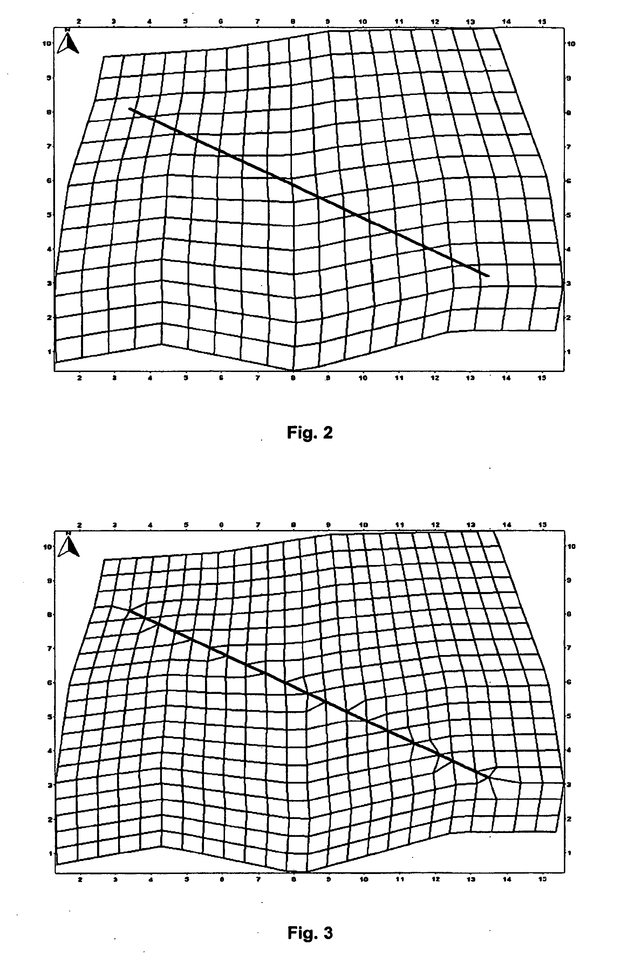

- la figure 2 montre un quadrillage de dimension 20 x 15 et une faille à caler

- la figure 3 montre le même quadrillage après le calage avec la faille

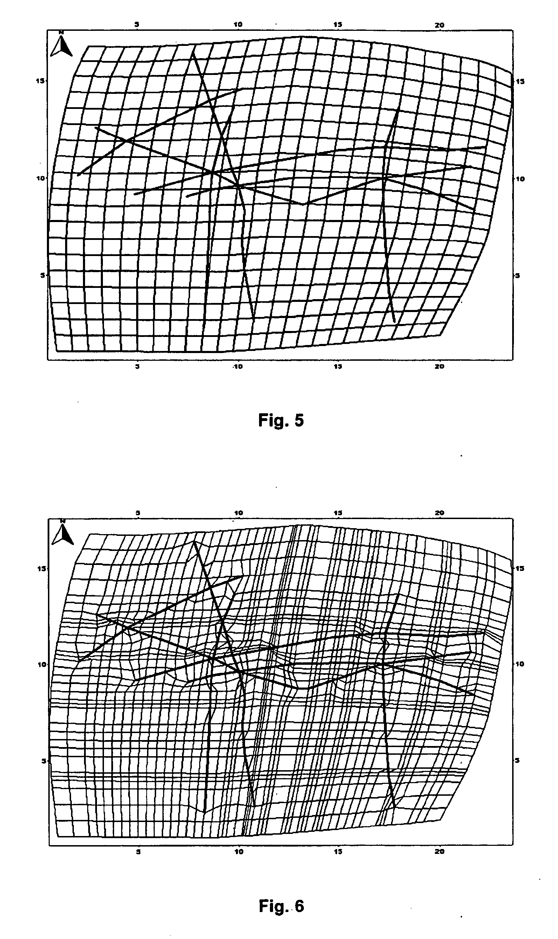

- la figure 5 montre un quadrillage de dimension 25 x 20 avec 7 failles avant le calage

- la figure 6 montre le même quadrillage après le calage avec ces 7 failles. La dimension est devenue 51 x 33

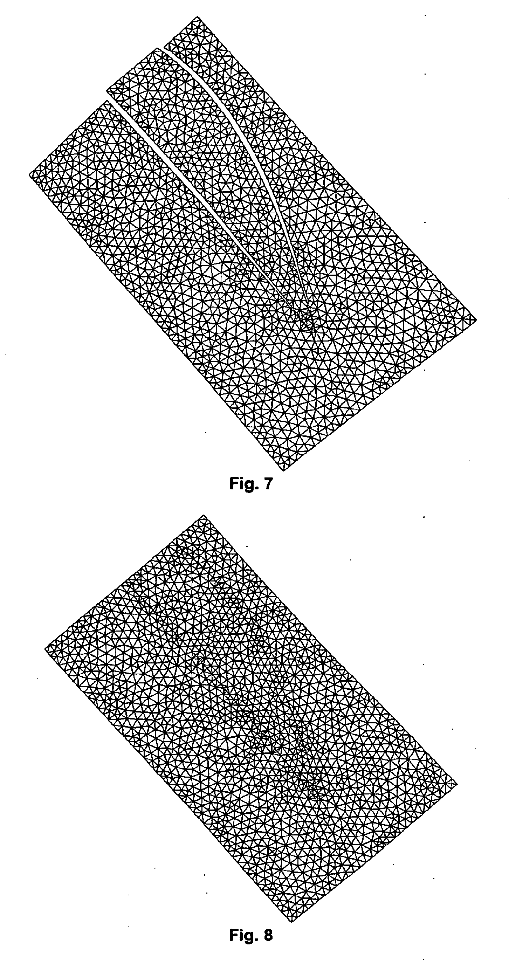

- les figures 7 à 11 montrent l'enchaînement des démarches de la méthodologie proposé par la présente invention, en appliquant sur un cas réel

- la figure 7 montre un horizon réel 3D triangulé

- la figure 8 montre le même horizon déplié

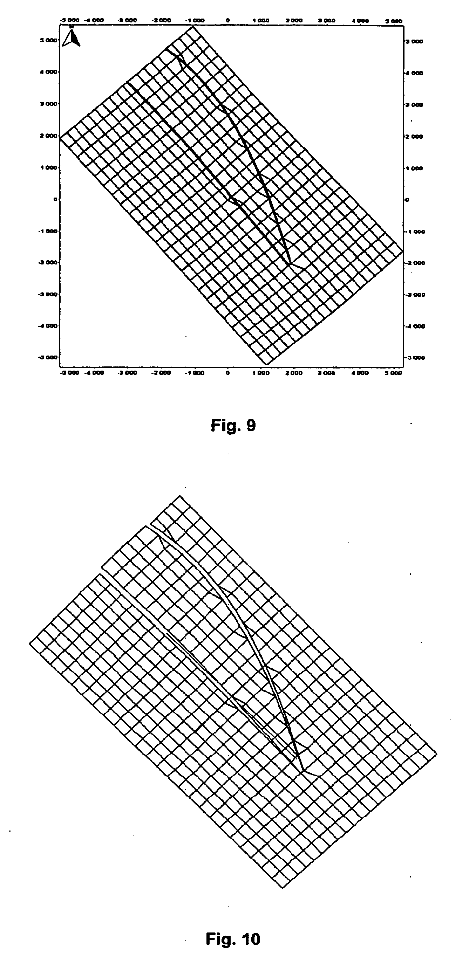

- la figure 9 montre le quadrillage généré sur l'horizon déplié et calé avec les failles

- la figure 10 montre le quadrillage après le report en horizon réel 3D

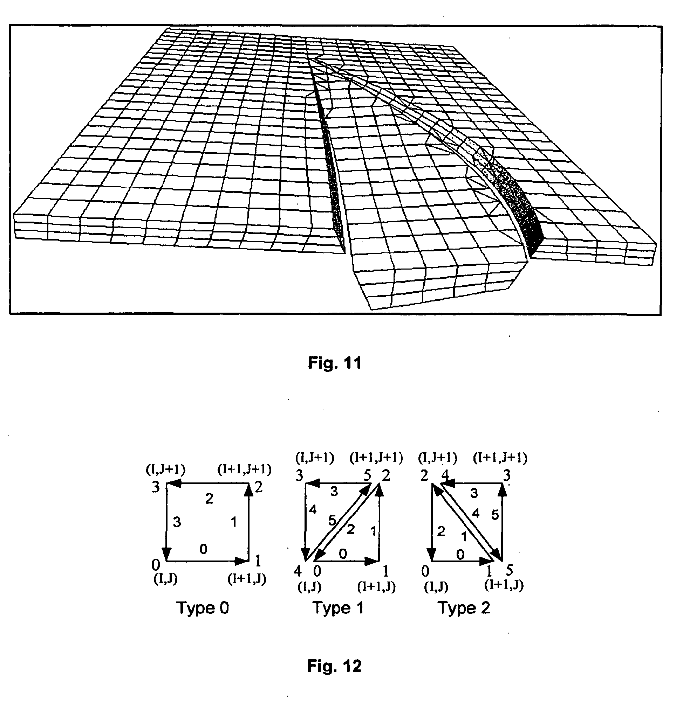

- la figure 11 montre le maillage hexa-dominant généré en mettant correspondance de deux horizons voisins

- la figure 12 montre les 3 types d'éléments d'un quadrillage reporté en horizon 3D

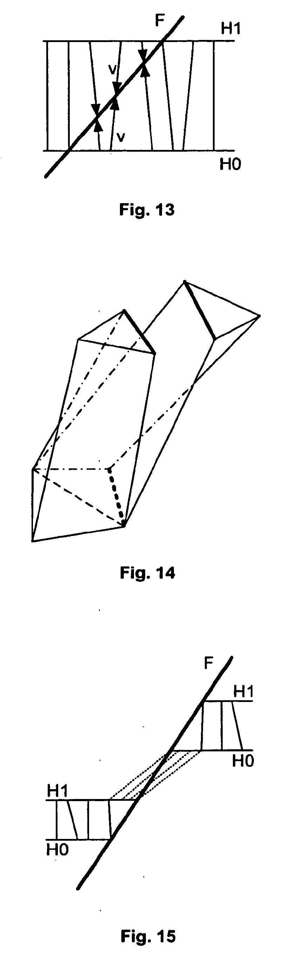

- la figure 13 montre le principe de la mise en correspondance de deux horizons

- les figures 14 et 15 montrent le problème de la mise en correspondance de deux horizons en zone faillée

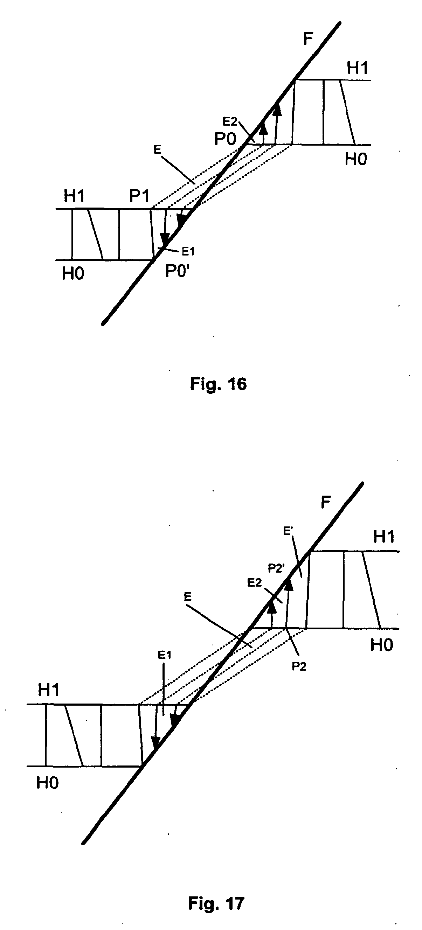

- les figures 16 et 17 montrent la solution au problème ci-dessus.

**Description détaillée de la méthode**

L'invention concerne une méthode pour générer un maillage tridimensionnel d'un milieu souterrain, prenant en compte les déformations induites par les failles du milieu, et comportant un maximum de mailles hexaédriques. Le maillage est ainsi adapté à l'étude des écoulements au sein du milieu. Couplée à un simulateur d'écoulement, l'invention propose une technique pour évaluer, en accord avec un schéma numérique défini, des écoulements de fluides dans un milieu poreux à géométrie complexe en présence des failles. Le milieu souterrain comprend au moins une couche sédimentaire traversée par au moins une faille. Une couche sédimentaire est délimitée verticalement par deux horizons géologiques discrétisés par deux surfaces tridimensionnelles triangulées.

Les figures 7 à 11 illustrent les différentes étapes de la méthode pour générer le maillage du milieu souterrain. Elle comprend les étapes suivantes :

1. on transforme chaque surface tridimensionnelle en une surface bidimensionnelle triangulée sur laquelle on projette la faille, au moyen d'une technique de dépliage isométrique, la faille ainsi projetée formant des segments décrivant une courbe ouverte ;

2. on génère un quadrillage bidimensionnel régulier pour chaque surface bidimensionnelle triangulée ;

3. on prend en compte la faille au sein du quadrillage régulier, en déformant des quadrilatères du quadrillage intersectés par la courbe ;

4. on transforme le quadrillage régulier ainsi déformé en une surface quadrillée tridimensionnelle, et on transforme en deux triangles chaque quadrilatère traversé par la faille au niveau d'une diagonale ;

5. on réitère les étapes précédentes pour la seconde surface tridimensionnelle triangulée en conservant un même nombre de quadrilatère dans chaque direction ;

6. on génère le maillage du milieu souterrain en créant des liaisons entre les noeuds de surfaces quadrillées tridimensionnelles voisines, tout en respectant la faille.

_1. Étape de dépliage isométrique_

Cette étape consiste à déplier d'une façon isométrique les surfaces 3D triangulée de façon à obtenir une surface 2D triangulée. Cette étape permet de coudre les déchirures des failles présentes sur les surfaces 3D triangulée.

On appelle « dépliage » une transformation d'une surface 3D en une surface 2D (opération consistant à mettre à plat une surface). Cette transformation est « isométrique » lorsqu'elle conserve les mesures, telles que les longueurs des arêtes, et donc les surfaces telles les aires des triangles.

Le spécialiste connaît des outils et des méthodes pour réaliser un dépliage isométrique de surface. La méthode selon l'invention ne dépend pas du type de méthode.

_2. Étape de quadrillage_

Cette étape consiste à générer un quadrillage 2D régulier, à partir de la bordure de la surface 2D triangulée. On appelle quadrillage, un canevas (ensemble des lignes et des points principaux d'une figure) plan constitué par deux familles de droites perpendiculaires délimitant des carrés.

On génère ce quadrillage régulier au moyen des étapes suivantes :

- on choisit quatre points sur la bordure de la surface 2D triangulée, définissant ainsi quatre courbes sur la bordure, appelées courbes frontalières, reliant ces quatre points. Ces quatre points sont préférentiellement ceux au niveau desquels la bordure forme les angles les plus petits. On les appelle « coin ».

- on choisit les dimensions du quadrillage (deux entiers notés N et M), et l'on discrétise alternativement chacune des quatre courbes en fonction de ces dimensions.

Pour tous les quadrillages, on met en correspondance un coin et on oriente les courbes frontalières de telle manière que le domaine se trouve à gauche. Le domaine est ici un terme mathématique, c'est la forme géométrique qu'on veut mailler. Cette étape sert à orienter tous les horizons de la même façon pour faciliter l'étape finale : la mise en correspondance des horizons. Puis, on subdivise les courbes frontalières en N ou M segments de longueur constante, N et M étant les mêmes que le quadrillage en dessous.

- on applique la version discrétisée la formule de Coons pour construire le quadrillage régulier s'appuyant sur l'horizon déplié (surface 2D triangulée).

On rappelle la formule de Coons :

Étant donné quatre courbes paramétriques f1(u), f2(u), g1(v), g2(v) ($0 \leq u$, $v \leq 1$) définissant quatre bords jointifs, la formule de Coons calcule la surface la plus tendue qui passe par les quatre bords (qui interpole ces bords) :

$$S(u,v) = (1-u)g1(v) + ug2(v) + (1-v)f1(u) + vf2(u) - [(1-u)(1-v)P(0,0) + ((1-u)vP(0,1) + u(1-v)P(1,0) + uvP(1,1)]$$

Les sommets P(i,j) sont les quatre coins de la surface.
On peut alors obtenir un maillage régulier NxM de cette surface par simple échantillonnage en prenant pour sommets les points S(i,j) correspondant aux ui = i/(N-1), vj = j/(M-1), i=0 à N-1, j=0 à M-1. La formule restreinte aux points du maillage devient:

$$S(i,j) = (1 - \frac{i}{N-1})g1(j) + \frac{i}{N-1}g2(j) + (1 - \frac{j}{M-1})f1(i) + \frac{j}{M-1}f2(i)$$

$$-[(1 - \frac{i}{N-1})(1 - \frac{j}{M-1})P(0,0) + (1 - \frac{i}{N-1})\frac{j}{M-1}P(0,1)$$

$$+ \frac{i}{N-1}(1 - \frac{j}{M-1})P(1,0) + \frac{i}{N-1}\frac{j}{M-1}P(1,1)]$$

3. Étape de calage des failles sur le quadrillage

La prise en compte d'une faille consiste à déformer le maillage de façon à ce qu'il soit conforme à la réalité du milieu souterrain à mailler. En effet, si une faille traverse un milieu, généralement les couches sédimentaires de ce milieu sont cassées et déformées. Le maillage doit donc rendre compte de ces déformations induites par les failles.

*Cas d'une faille unique*

Au cours de cette étape, on prend en compte la faille au sein du quadrillage régulier, en réalisant les étapes suivantes :

- on détermine une première arête du quadrillage intersectée par la courbe ouverte, en parcourant cette courbe segment par segment et en partant de l'une de ses extrémités ;
- on déplace l'extrémité de l'arête intersectée la plus proche du point d'intersection vers le point d'intersection.

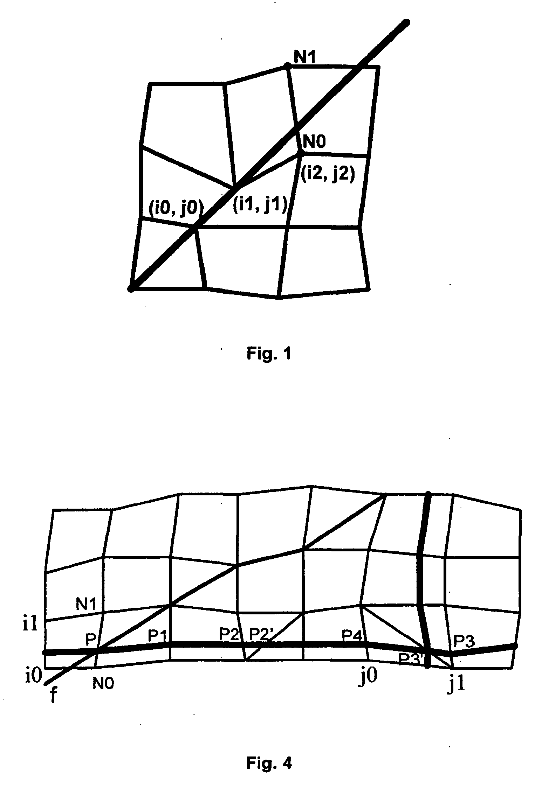

Une difficulté peut apparaître du fait que l'on puisse produire des quadrilatères dégénérés en faisant bouger cette extrémité. Ce problème est illustré sur la figure 1 :

Soient trois noeuds tels que :

- (i2, j2) le noeud à faire bouger

- (i1, j1) le noeud bougé juste avant (i2, j2)

- (i0 j0) le noeud bougé juste avant (i1, j1)

Si (i0 = i1 ou j0 = j1) alors (i0, j0) et (i1, j1) forment une arête (deux noeuds bougés successivement forment soit une diagonale, soit une arête d'un quadrilatère). De même, (i1, j1) et (i2, j2) forment une deuxième arête si on a (i1 = i2 ou j1 = j2). Par conséquent, ces deux arêtes construites seront dans le même quadrilatère si |i0 - i2| = 1 et |j0 - j2| = 1 et seront considérées comme alignées si l'angle entre elles dépasse un certain seuil d'alignement. Cette situation n'est pas acceptable car les hexaèdres ayant ce quadrilatère comme face seront torsadés. Pour surmonter cette difficulté, avant de déplacer l'extrémité la plus proche, on vérifie que ce déplacement n'engendre pas un quadrilatère dégénéré. On qualifie de dégénéré un quadrilatère dont au moins un angle est supérieur à un seuil d'angle fixé. Si effectivement, le fait de déplacer l'extrémité la plus proche engendre un tel quadrilatère, alors on déplace l'autre extrémité de l'arête intersectée. Selon l'exemple de la figure 1, on bouge l'autre extrémité de l'arête intersectée par la faille au lieu de (i2, j2).

La méthode étant mise en oeuvre par un ordinateur on décrit l'algorithme relatif à cette étape. L'algorithme démarre par l'identification du quadrilatère qui contient le premier point de la faille. Puis, l'intersection entre le premier segment de la faille et les arêtes de ce quadrilatère est calculée. Si aucune intersection n'est détectée, on passe au segment suivant de la faille et on boucle jusqu'à ce qu'une intersection soit trouvée. Ensuite, on bouge l'extrémité de l'arête intersectée la plus proche du point d'intersection vers celui-ci. S'il en résulte la formation d'un quadrilatère dégénéré, c'est l'autre extrémité de l'arête qui est bougée. Pour calculer l'intersection suivante, on avance dans les quadrilatères ayant le dernier noeud épousé en commun, en excluant ceux qui ont les deux derniers noeuds épousés comme une diagonale ou une arête. S'il n'y a plus d'intersection entre le segment courant et les quadrilatères à visiter, on réaffecte les quadrilatères à visiter avec ce qui contient le bout du segment courant, et on passe au segment suivant pour calculer l'intersection, et ainsi de suite. A la fin, on cale les deux bouts de la faille avec les noeuds les plus proches.

A titre d'illustration, l'algorithme peut ainsi être décrit :

```
SegmentFaille ← 0 ;
q ← le quadrilatère conteneur du premier point de la faille ;
quadsAVisiter ← q ;
quadsAExclure ← nul ;


tant que segmentFaille < nombre total des segments faille
        calculer l'intersection du segmentFaille avec les quadsAVisiter en excluant les quadsAExclure ;
        n ← la bonne extrémité de l'arête intersectée ;
        si n != -1 alors
                quadsAExclure ← les quadrilatères ayant n et le dernier nœud épousé comme
                                arête/diagonale ;
                quadsAVisiter ← les quatre quadrilatères ayant n en commun ;
        sinon
                quadsAVisiter ← le quadrilatère où se trouve la deuxième extrémité du segmentFaille ;
                quadsAExclure ← nul ;
                segmentFaille ← segmentFaille + 1 ;
        fin si
fin tant que


épouser le premier point de la faille avec le coin le plus proche de q ;
pour chaque quadrilatère dans quadsAVisiter faire
        si le dernier point de la faille est dans quadrilatère alors
                épouser le dernier point de la faille avec le coin le plus proche du quadrilatère ;
                retourner ;
        fin si
fin pour
```

Les deux figures 2 et 3 montrent un quadrillage avant et après la prise en compte d'une faille unique. La ligne droite noire est la courbe ouverte représentant la faille. Elle ne fait pas partie du maillage.

*Cas de failles multiples*

En présence de failles multiples, tous les noeuds du quadrillage ne sont pas libres de bouger, car un noeud qui a déjà été déplacé pour prendre en compte une première faille, ne doit pas être modifié pour prendre en compte une deuxième faille. L'algorithme de calage doit donc tenir compte de ce nouveau contexte plus contraignant, et une procédure de raffinement est à effectuer éventuellement pour se délibérer de cette contrainte.

Selon l'invention, on prend en compte de multiples failles au sein du quadrillage régulier, en réalisant les étapes suivantes :

- on détermine une première arête dudit quadrillage intersectée par ladite ligne ouverte, en parcourant ladite ligne segment par segment et en partant d'une extrémité de ladite ligne ouverte ;

- on déplace l'extrémité de l'arête la plus proche du point d'intersection vers ledit point d'intersection si ce déplacement n'engendre pas un quadrilatère dont au moins un angle est supérieur à un seuil d'angle fixé, et si cette extrémité n'a pas déjà été déplacée ; sinon

- on déplace l'autre extrémité vers ledit point d'intersection si cette extrémité n'a pas déjà été déplacée ; sinon

- on raffine le maillage, jusqu'à ce qu'une extrémité puisse être déplacée, et on déplace cette extrémité.

Le raffinement du maillage peut être réalisé au moyen des étapes suivantes :

- on ajoute un nouveau noeud au maillage, correspondant à un point d'intersection entre une faille et l'arête pour laquelle aucune extrémité ne peut être déplacée ;

- si l'arête est verticale, on dédouble la ligne complète du quadrillage contenant le point d'intersection, en ajoutant une succession d'arêtes horizontales, dans tous les quadrilatères de la ligne, la succession d'arêtes passant par le point d'intersection ;

- si l'arête est horizontale, on dédouble la colonne complète du quadrillage contenant le point d'intersection, en ajoutant une succession d'arêtes verticales, dans tous les quadrilatères de la colonne, la succession d'arêtes passant par le point d'intersection.

Ce raffinement est également appliqué à tous les horizons situés plus bas, si l'on traite les horizons du plus bas vers le plus haut.

La méthode étant mise en oeuvre par un ordinateur on décrit l'algorithme relatif à cette étape. Pour décrire si un noeud est contraint par une ou plusieurs failles, deux notions sont introduites : la première dite « Degré faillé d'un noeud » et la deuxième dite « Failles passantes d'un noeud ».

*Degré faillé d'un noeud* : Un noeud S est dit de degré faillé n s'il est le point d'intersection de n failles. Si n est nul, alors aucune faille ne passe par ce noeud. On suppose ci-après « *df* » le foncteur qui retourne le degré faillé d'un noeud. Les degrés faillés des noeuds sont stockés comme une propriété du quadrillage, utiles pour la phase de prise en compte des failles, pour vérifier si un noeud est contraint par des failles, pour la phase d'optimisation du quadrillage (df = 0 : bouger librement le noeud ; df = 1 : projeter sur la faille passante ; df >= 2 : ne pas bouger), et enfin, pour la phase de report en 3D du quadrillage, pour décider quand et comment un noeud est dédoublé.

*Failles passantes d'un noeud* : c'est la liste de failles qui passent par un noeud. On suppose ci-après « faillesPassantes » le foncteur pour récupérer les failles qui passent par un noeud.

Le processus global du calage des failles multiples itère de bas en haut sur tous les horizons, pour générer des quadrillages réguliers et y caler les failles. Pour chaque horizon, on génère d'abord un quadrillage de la même dimension que ceux situés plus bas (géologiquement plus anciens), puis on cale tous les points d'intersection entre les failles et les extrémités des failles. On itère ensuite sur toutes les failles pour les prendre en compte dans le maillage. Lorsqu'un raffinement est nécessaire sur un quadrillage d'un horizon pour épouser une faille, les quadrillages des horizons déjà traités subissent de manière exhaustive le même raffinement, pour garder une seule dimension pour tous les quadrillages.

Concernant les structures des données, compte tenu du fait que le nombre des noeuds d'un quadrillage sur un horizon peux augmenter suite à un raffinement, une liste chaînée est utilisée pour représenter le quadrillage, afin de faciliter l'ajout d'un nouveau noeud à une position quelconque. Aussi, les noeuds traversés par une faille (nommé « noeudsEpousés ») sont enregistrés dans une liste chaînée pour permettre une insertion rapide.

Pour caler une faille donnée, on cherche, segment par segment, les points d'intersection entre la faille et le quadrillage, et on décide les noeuds à bouger jusqu'à ces points d'intersection. Un point d'intersection est calculé de la façon suivante : on commence par le premier noeud dans noeudsEpousés qui représente le début du premier segment de la faille, on récupère les quatre cellules voisines de ce noeud dit « noeud courant », et on cherche l'intersection du premier segment appelé « segment courant » avec ces quatre cellules. Si une intersection est trouvée, on choisit une extrémité de l'arête intersectée pour la bouger jusqu'au point d'intersection. Les cellules voisines du noeud représentant cette intersection deviennent les cellules à visiter pour calculer l'intersection suivante avec le même segment de faille, à l'exclusion de celles qui ont comme arête ou diagonale le nouveau noeud épousé et celui d'avant. S'il n'y a plus d'intersection entre le segment courant et les cellules à visiter, on réaffecte les cellules à visiter avec celle qui contient le bout du segment courant, et on passe au segment suivant pour calculer l'intersection, ainsi de suite.

Au cours du parcours de la faille, on peut rencontrer des points déjà épousés qui représentent par exemple les intersections de la faille avec autres failles présentes sur le même horizon. Il faut donc vérifier pour le noeud dernièrement épousé, s'il existe un noeud en avant dans noeudsEpousés. Si oui, si les deux noeuds forment une arête ou une diagonale d'un quadrilatère, le noeud en avant devient le noeud courant pour calculer les cellules à visiter, et on passe au segment faille qui correspond à ce noeud pour continuer le calcul d'intersection. A titre d'illustration, l'algorithme peut ainsi être décrit :

```
segmentFaille ← 0 ;

nœudCourant ← premier élément dans noeudsEpousées ;

cellulesAVisiter ← les quatre cellules ayant noeudCourant en commun ;

cellulesAExclure ← nul ;


tant que vrai faire

        noeudEnAvant ← le nœud qui suit noeudCourant dans noeudsEpousées si il existe, -1 sinon ;


        si noeudCourant et noeudEnAvant forment une arête ou une diagonale alors

                si noeudEnAvant est le dernier dans noeudsEpousées alors

                        retourner ;

                fin si


                n ← noeudEnAvant ;

                segmentFaille ← le segment de faille où se trouve n;

        sinon

                calculer l'intersection du segmentFaille avec les quadsAVisiter en excluant les
                        quadsAExclure ;

                n ← la bonne extrémité de l'arête intersectée ;

        fin si


        si n != -1 alors

                cellulesAExclure← les cellules ayant n et noeudCourant comme arête ou diagonale ;

                noeudCourant ← n ;

                cellulesAVisiter ← les quatre cellules ayant noeudCourant en commun ;

        sinon si segmentFaille < nombre total des segments faille alors

                cellulesAVisiter ← la cellule ou se trouve la deuxième extrémité du segmentFaille ;

                cellulesAExclure ← nul ;

                segmentFaille ← segmentFaille + 1 ;

        sinon

                retourner ;

        fin si

fin tant que
```

Le processus de raffinement est déclenché par l'ajout comme un nouveau noeud d'un point d'intersection entre une faille et un quadrillage. Voir la figure 4 : soit P le point d'intersection, NON1 l'arête où se situe P. Si cette arête est horizontale, une succession d'arêtes verticales est ajoutée entre les arêtes verticales d'indexes i0 et i1. Par contre, si cette arête est verticale, les arêtes ajoutées sont horizontales et se situeront entre les arêtes horizontales d'indexes j0 et j1. Les extrémités de ces nouvelles arêtes peuvent garder la même proportion que N0P/N0N1 sur leurs arêtes « mère » correspondantes, mais les points centraux sont préférables pour plus de régularité. Ces extrémités sont insérées dans la liste chaînée représentant le quadrillage, avec nx ou ny incrémenté de 1.

Les nouvelles arêtes peuvent être intersectées par les segments des failles déjà épousés, représentées soit par une arête, soit par une diagonale d'un quadrilatère. Si c'est le premier cas, le point d'intersection est aussi un noeud (ex. P1 dans la figure 4). Il faut alors insérer ce noeud dans « noeudsEpousés » de la faille correspondante. Dans le deuxième cas, il faut d'abord essayer de déplacer l'extrémité de la nouvelle arête plus proche du point d'intersection (ex. bouger P2 à P2' dans la figure 4) ; si cette extrémité est sur une faille, il faut bouger l'autre extrémité. Si les deux extrémités sont figées par des failles, il faut encore raffiner (ex. raffiner sur P3' dans la figure 4).

Les figures 5 et 6 montrent un quadrillage avant et après déformation pour prendre en compte sept failles. On note qu'un raffinement a été nécessaire.

La figure 9 montre un quadrillage prenant en compte les failles.

4. Étape de report du quadrillage en horizon réel

Cette étape consiste à reporter le quadrillage régulier, déformé pour tenir compte des failles, en horizon réel 3D.

Selon l'invention, on peut transformer le quadrillage régulier en une surface quadrillée à trois dimensions en effectuant un changement de repère, du repère du quadrillage régulier au repère de la surface 3D triangulée, des noeuds du quadrillage. Les coordonnées des noeuds hors faille sont déterminées à partir de leurs coordonnées barycentriques dans un repère défini par le triangle de la surface triangulée 2D auquel ils appartiennent. Les coordonnées des noeuds situés sur une faille sont déterminées à partir de leurs abscisses curvilignes sur la faille. Les connectivités sont ensuite établies de façon à maximiser le nombre de quadrilatère, seuls les quadrilatères pour lesquels une faille passe par l'une de ses diagonales, sont divisés en deux triangles.

En particulier on peut réaliser les étapes suivantes :

- on positionne les noeuds dans le repère 3D :

    - pour chaque noeud du quadrillage situé sur une faille, on détermine l'abscisse curviligne dudit noeud sur la faille, puis on reporte ce noeud sur la faille dans le repère 3D au moyen de cette abscisse curviligne, et on dédouble ce noeud sur chaque coté de la lèvre de la faille si nécessaire ;

    - pour chaque noeud du quadrillage situé en dehors une faille, on détermine les coordonnées barycentriques de chaque noeud dudit quadrillage dans un repère défini par le triangle de la surface triangulée 2D auquel le noeud appartient, puis on positionne chaque noeud dans un repère défini par le triangle de la surface triangulée 3D auquel le noeud appartient, en fonction desdites coordonnées barycentriques ;

- on connecte ces noeuds par des arêtes de façon à obtenir une surface 3D maillée avec un maximum de quadrilatère, seuls les quadrilatères pour lesquels une faille passe par l'une de ses diagonales, sont divisés en deux triangles, comme l'illustre la figure 10.

La méthode étant mise en oeuvre par un ordinateur on décrit l'algorithme relatif à cette étape. La structure principale est nommée "SplittedGrid", elle représente un quadrillage 3D quasi-régulier, avec certains noeuds (I, J) dédoublés en deux ou plus. La figure 12 montre trois types de cellules pseudo-quadrilatère : quadrilatère normal, quadrilatère dédoublé en deux triangles par la diagonale allant de gauche inférieure à droite supérieure, quadrilatère dédoublé en deux triangles par la diagonale allant de droite inférieure à gauche supérieure. La numérotation locale des noeuds et des arêtes du quadrilatère est aussi indiquée dans le schéma. Avec cette notion des cellules pseudo-quadrilatère, le quadrillage reporté en horizon réel 3D reste une surface IJ.

Une "SpllitedGrid" est décrite par :

- $nx$ et $ny$ : nombre de colonnes et de lignes

- $nodes$ : liste des noeuds (I, J) ;

- $cells$ : liste des cellules

Pour un noeud (1, J), sont stockées les informations suivantes :

- nombre des noeuds dédoublés

- triangle conteneur et les coordonnées barycentriques dans le triangle, si le noeud n'est pas dédoublé ;

- pour chaque noeud dédoublé : numéro de faille, référence du côté de la faille, numéro du segment de la faille et abscisse curviligne du noeud sur ce segment. Quand le noeud représente une intersection entre des failles, les informations stockées sont plutôt le numéro du noeud dans la triangulation, la référence du côté d'une faille, l'autre référence du côté de l'autre faille.

- pour chaque noeud dédoublé : coordonnées x, y, z

Pour une cellule pseudo-quadrilatère, sont stockées les informations suivantes :

- type de la cellule

- nombre de sommets

- tableau de sommets

L'algorithme démarre par un parcours des noeuds du quadrillage régulier 2D épousé avec les failles. Pour chaque noeud (I, J), leurs failles passantes sont d'abord récupérées. S'il n'y a pas de failles passantes, un triangle conteneur du noeud dans la triangulation dépliée est localisé, le noeud correspondant sur l'horizon réel 3D est calculé en utilisant les coordonnées barycentriques du triangle du même numéro sur la triangulation originale 3D. Si le noeud (I, J) se trouve sur une seule faille, est d'abord récupéré le segment de la faille où se trouve ce noeud en espace déplié. L'abscisse curviligne du noeud sur ce segment est ensuite calculée. Puis, les deux noeuds correspondants dédoublés sont calculés en utilisant cette abscisse curviligne sur le même segment en deux côtés de la faille en espace réel. Pour un noeud se situant à l'intersection des failles, son numéro dans la triangulation est récupéré, les références des côtés de failles qui s'y intersectent sont enregistrées.

A part les coordonnées, les informations concernant les failles ou le triangle conteneur sont stockées pour faciliter la génération du maillage volumique par la mise à correspondance des horizons.

Une fois que les noeuds du quadrillage déplié sont reportés en horizon réel, la connectivité entre ces noeuds est établie en formant des cellules pseudo-quadrilatères. Ces cellules sont construites une par une en parcourant d'abord la direction I puis J. Le type de la cellule courante est d'abord déterminé. Pour ce faire, il faut juste vérifier s'il y a une faille passante sur l'une de deux diagonales du quadrilatère en quadrillage déplié. Si oui, le type est 1 ou 2, si non, le type est 0. Le nombre de sommets pour la cellule courante est alors obtenu en fonction de son type, ainsi que l'indice (I, J) de chaque sommet. Avec cet indice, on vérifie si un sommet est dédoublé ou pas, en examinant la liste de noeuds (I, J) préalablement remplis. Si tous les sommets sont dédoublés, on ajoute la cellule courante dans une liste temporaire, qui sauvegarde les cellules avec tous ses sommets dédoublés pour traiter à la fin, et on passe à la cellule suivante. Sinon, le noeud IJ non dédoublé est tout de suite reporté, car il y a un seul noeud 3D correspondant. Pour chaque noeud de la cellule courante déjà reporté, les noeuds adjacents et opposés dédoublés dans la cellule sont calculés de la façon suivante : si le noeud non dédoublé et celui adjacent est sur la même faille, on choisit le noeud de même côté de la faille ; sinon, on prend le centième point sur l'arête constituée par le noeud non dédoublé et celui adjacent, on le localise dans la triangulation dépliée, on le reporte en triangulation réelle en utilisant le même triangle et les mêmes coordonnées barycentriques. On calcule ensuite la distance entre le point reporté et tous les noeuds dédoublés du noeud IJ adjacent, on choisit le noeud le plus proche comme le sommet correspondant de la cellule courante. Pour le noeud opposé au noeud courant (déjà reporté) de la diagonale, on choisit le noeud dédoublé sur l'autre côté de la faille. Cette procédure reboucle jusqu'à ce que tous les sommets soient reportés.

Pour une cellule avec tous ses sommets dédoublés, pour chacune de ses arêtes, l'arête en face dans la cellule voisine est repérée, la référence de la faille où se trouve cette arête en face est récupérée, l'arête courante est donc sur l'autre côté de la faille avec une référence différente. Les noeuds dédoublés correspondants sont ainsi déterminés selon cette référence. La figure 10 montre le quadrillage de la figure 9 reporté en horizon réel 3D.

5. Étape d'itération

Les étapes 1 à 4 sont réitérées pour chaque surface tridimensionnelle triangulée, en conservant un même nombre de quadrilatère dans chaque direction.

6. Étape de mise en correspondance de deux horizons

Cette étape consiste à construire un maillage tridimensionnel du milieu, en reliant directement les noeuds ayant les mêmes coordonnées I, J sur deux horizons voisins de façon à former des mailles tridimensionnelles, et à découper éventuellement ces mailles si elles sont traversées par la faille : si une faille intersecte cette liaison on relie un noeud avec la faille en considérant une direction d'un noeud voisin. Ceci est illustré sur la figure 13.

Quand un quadrilatère sur l'un de deux horizons est dédoublé en deux triangles via une faille qui passe par la diagonale, le quadrilatère correspondant sur l'autre horizon est aussi virtuellement découpé de la même manière et deux prismes seront formés. Pourtant, un des deux prismes est torsadé et l'interface de la faille n'est pas respectée. Dans la figure 14, les segments dessinés en gras sont sur la même surface de faille, on voit que le quadrilatère en bas à gauche de la faille rejoint deux triangles en haut à gauche et à droite de la faille.

Une configuration problématique est produite quand les horizons sur les deux côtés de la faille glissent sur celle-ci, comme l'illustre la figure 15 : des éléments sont incorrectement construits en dehors de la couche formée entre les horizons H0 et H1 en reliant les mêmes i et j.

La malformation des éléments correspondants aux deux configurations ci-dessus, est due à un choix incorrect de la direction de lien entre deux horizons. La solution réside ainsi dans la détection et la correction des mauvaises directions. Pour détecter la présence d'une mauvaise direction pendant la création d'un élément 3D, on vérifie d'abord s'il existe un segment reliant les même I, J qui traverse une faille. Si oui, l'élément 3D comprend effectivement des directions à corriger et il doit être remplacé par deux éléments 3D qui suivent les directions corrigées. Sinon, on vérifie de plus s'il existe une faille qui passe par deux arêtes de l'élément 3D, une sur l'horizon en haut et une autre sur celui en bas. Si oui et si les indices locaux de ces deux arêtes sont différents, l'élément est aussi à corriger. Soit E l'élément 3D en question, F la faille traversante, E1 E2 les deux éléments 3D à créer pour remplacer E. Les bonnes directions sont calculées de la façon suivante :

- on parcourt d'abord tous les noeuds de E en H0 pour trouver les noeuds sur une faille F. Soit P0 un tel noeud. Il existe donc un autre noeud ayant le même IJ qui se trouve sur l'autre côté de cette faille en H0, soit P0'. Soit P1 le noeud en H1 lié à P0 dans E. Au lieu de lier P0 à P1, on lie P0' à P1, P0 à lui même et on associe P0'P1 à E1, P0 à E2. E2 est réduit à un tétraèdre (si E est un prisme) ou un prisme (si E est un hexaèdre). On enregistre P0'P1 en tant qu'une bonne direction de E1. On répète cette procédure sur H1 pour retrouver de bonnes directions d'E2.

- s'il n'y a aucun noeud sur la faille F en H0, on cherche un élément 3D voisin de E par un noeud de E en H0. soit E' l'élément 3D voisin choisi, P2 le noeud en commun, et P2' le noeud en H1 relié à P2 dans E'. On relie P2 à P2' dans E2 et on enregistre P2P2' en tant qu'une bonne direction de E2. De même on calcule la bonne direction de E1 quand aucun noeud en faille F ne se trouve en H1.

En suivant les directions corrigées en E2, tous les noeuds en H0 non encore traités sont projetés sur la surface de faille et liés à ses images correspondantes. Et tous les noeuds en H1 non encore traités sont projetés sur la surface de faille en suivant les directions corrigées en E1, comme l'illustre les figures 16 et 17.

La figure 11 illustre le résultat final d'une mise en correspondance à partir du quadrillage de la figure 10.

Un maillage construit selon l'invention est particulièrement adapté pour simuler les écoulements au sein d'un milieu souterrain en zone à géométrie complexe. L'invention fournit ainsi un outil précis pour réaliser une modélisation de bassin, une simulation de réservoir, ou des simulations d'injection de $CO_2$ dans une formation souterraine. Une méthode pour simuler les écoulements au sein d'un milieu souterrain en zone à géométrie complexe, comprend la génération d'un maillage hexa-dominant à partir de la méthode selon l'invention, puis la réalisation de simulations au moyen d'un logiciel adapté (simulateur de bassin ou simulateur de réservoir) s'appuyant sur le maillage ainsi généré. Ces simulations permettent aux spécialistes d'optimiser l'exploration de champ pétrolier, l'exploration ou l'exploitation de réservoir souterrain, ou l'injection de gaz dans des milieux souterrains.

**Revendications**

1. Méthode pour générer un maillage d'un milieu souterrain comprenant au moins une couche sédimentaire traversée par au moins une faille, ladite couche étant délimitée verticalement par deux horizons géologiques discrétisés par deux surfaces tridimensionnelles triangulées, **caractérisée en ce que** :

   - on transforme chaque surface tridimensionnelle triangulée en une surface bidimensionnelle triangulée sur laquelle on projette ladite faille, au moyen d'une technique de dépliage isométrique, la faille ainsi projetée formant des segments décrivant une courbe ouverte ;

- on génère un quadrillage bidimensionnel régulier pour chaque surface bidimensionnelle triangulée ;
- on déforme ledit quadrillage bidimensionnel régulier en déterminant une première arrête dudit quadrillage intersectée par ladite courbe ouverte, en parcourant ladite courbe segment par segment et en partant d'une extrémité de ladite courbe ouverte ; puis en déplaçant l'extrémité de l'arête intersectée la plus proche du point d'intersection vers ledit point d'intersection ;
- on effectue un changement de repère pour transformer ledit quadrillage régulier ainsi déformé en une surface quadrillée tridimensionnelle, et on transforme en deux triangles chaque quadrilatère traversé par ladite faille au niveau d'une diagonale ;
- on réitère les étapes précédentes pour la seconde surface tridimensionnelle triangulée en conservant un même nombre de quadrilatère dans chaque direction ;
- on génère ledit maillage du milieu souterrain en créant des liaisons entre chaque noeud de chaque quadrilatère et de chaque triangle des deux surfaces quadrillées tridimensionnelles, et en découpant chaque maille dudit maillage du milieu souterrain traversée par ladite faille.

2.  Méthode selon la revendication 1, dans laquelle ledit milieu comporte plus d'une couche sédimentaire, on construit ledit maillage en réitérant couche par couche.

3.  Méthode selon la revendication 1, dans laquelle on génère ledit quadrillage régulier au moyen des étapes suivantes :

- on choisit quatre points sur la bordure de la surface bidimensionnelle, définissant quatre courbes sur la bordure ;
- on choisit les dimensions du quadrillage (N, M), et l'on discrétise alternativement chacune des quatre courbes en fonction desdites dimensions;
- on applique la formule de Coons pour construire le quadrillage.

4.  Méthode selon l'une des revendications précédentes, dans laquelle avant de déplacer ladite extrémité la plus proche, on vérifie que ce déplacement n'engendre pas un quadrilatère dont au moins un angle est supérieur à un seuil d'angle fixé, si c'est le cas, on déplace l'autre extrémité de l'arrête intersectée.

5.  Méthode selon la revendication 1, dans laquelle ledit milieu comporte plusieurs failles, on prend en compte les failles au sein dudit quadrillage régulier, en réalisant les étapes suivantes :

- on détermine une première arête dudit quadrillage intersectée par ladite courbe ouverte, en parcourant ladite courbe segment par segment et en partant d'une extrémité de ladite courbe ouverte ;
- on déplace l'extrémité de l'arête la plus proche du point d'intersection vers ledit point d'intersection si ce déplacement n'engendre pas un quadrilatère dont au moins un angle est supérieur à un seuil d'angle fixé, et si cette extrémité n'a pas déjà été déplacée ; sinon
- on déplace l'autre extrémité vers ledit point d'intersection si cette extrémité n'a pas déjà été déplacée ; sinon
- on raffine le maillage, jusqu'à ce qu'une extrémité puisse être déplacée, et on déplace cette extrémité.

6.  Méthode selon la revendication 5, dans laquelle on raffine le maillage au moyen des étapes suivantes :

- on ajoute un nouveau noeud au maillage, correspondant à un point d'intersection entre une faille et l'arête pour laquelle aucune extrémité ne peut être déplacée ;
- si l'arête est verticale, on dédouble la ligne complète du quadrillage contenant le point d'intersection, en ajoutant une succession d'arêtes horizontales, dans tous les quadrilatères de la ligne, la succession d'arêtes passant par le point d'intersection;
- si l'arête est horizontale, on dédouble la colonne complète du quadrillage contenant le point d'intersection, en ajoutant une succession d'arêtes verticales, dans tous les quadrilatères de la colonne, la succession d'arêtes passant par le point d'intersection.

7.  Méthode selon l'une des revendications précédentes, dans laquelle on transforme ledit quadrillage régulier en une surface quadrillée à trois dimensions en réalisant les étapes suivantes :

- pour chaque noeud non situé sur une faille, on détermine ses coordonnées à partir de coordonnées barycentriques du noeud dans un repère défini par un triangle de la surface triangulée 2D auquel il appartient ;
- pour chaque noeud situé sur une faille, on détermine ses coordonnées à partir d'abscisses curvilignes mesurées sur ladite faille ;
- on établit des connectivités entre les noeuds de façon à maximiser un nombre de quadrilatères, seuls des quadrilatères pour lesquels une faille passe par l'une de ses diagonales sont divisés en deux triangles.

8. Méthode selon la revendication 7, dans laquelle on crée des liaisons entre les noeuds en reliant chaque noeud de chaque surface quadrillée tridimensionnelle ayant des mêmes coordonnées i, j, et si une faille intersecte cette liaison, on relie un noeud avec ladite faille en considérant une direction d'un noeud voisin.

**Patentansprüche**

1. Methode, um ein Netzwerk eines unterirdischen Mediums zu erzeugen, umfassend mindestens eine Sedimentlage, durch die hindurch mindestens ein Bruch verläuft, wobei die Lage vertikal von zwei geologischen Horizonten begrenzt ist, die durch zwei dreidimensionale, aus Dreiecken zusammengesetzte Flächen unterbrochen sind, **dadurch gekennzeichnet, dass**:

   - jede dreidimensionale, aus Dreiecken zusammengesetzte Fläche in eine zweidimensionale, aus Dreiecken zusammengesetzte Fläche umgeformt wird, auf die der Bruch mit Hilfe einer Technik der isometrischen Abstapelung projiziert wird, wobei der so projizierte Bruch Segmente bildet, die eine offene Kurve beschreiben;
   - für jede zweidimensionale, aus Dreiecken zusammengesetzte Fläche ein zweidimensionaler regelmäßiger Flächenraster erzeugt wird;
   - der zweidimensionale regelmäßige Flächenraster verformt wird, wobei eine erste Kante des Flächenrasters, die von der offenen Kurve geschnitten wird, bestimmt wird, wobei die Kurve Segment für Segment durchlaufen und von einem Ende der offenen Kurve ausgegangen wird; wobei dann das Ende der geschnittenen Kante, das sich am nächsten zum Schnittpunkt befindet, zu dem Schnittpunkt verschoben wird;
   - eine Bezugsänderung durchgeführt wird, um den so verformten regelmäßigen Flächenraster in eine dreidimensionale, aus Vierecken zusammengesetzte Fläche umzuformen, und jedes Viereck, durch das der Bruch im Bereich einer Diagonale hindurchgeht, in zwei Dreiecke umgeformt wird;
   - die vorherigen Schritte für die zweite dreidimensionale, aus Dreiecken zusammengesetzte Fläche reiteriert wird, wobei eine selbe Anzahl von Vierecken in jede Richtung beibehalten wird;
   - das Netzwerk des unterirdischen Mediums erzeugt wird, wobei Verbindungen zwischen jedem Knoten jedes Vierecks und jedem Dreieck der beiden dreidimensionalen, aus Vierecken zusammengesetzten Flächen hergestellt werden, und wobei jedes Glied des Netzwerks des unterirdischen Mediums, das von dem Bruch durchquert wird, abgeschnitten wird.

2. Methode nach Anspruch 1, bei der, wenn das Medium mehr als eine Sedimentlage umfasst, das Netzwerk zur Reiteration Lage für Lage hergestellt wird.

3. Methode nach Anspruch 1, bei der der regelmäßige Flächenraster mit Hilfe der folgenden Schritte erzeugt wird:

   - Auswahl von vier Punkten auf der Umrandung der zweidimensionalen Fläche, die vier Kurven auf der Umrandung definieren;
   - Auswahl der Dimensionen des Flächenrasters (N, M) und abwechselndes Unterbrechen der vier Kurven in Abhängigkeit von den Dimensionen;
   - Anwendung der Coons-Formel für die Konstruktion des Flächenrasters.

4. Methode nach einem der vorhergehenden Ansprüche, bei der vor dem Verschieben des nächsten Endes überprüft wird, ob diese Verschiebung nicht zu einem Viereck führt, bei dem mindestens ein Winkel größer als eine festgelegte Winkelschwelle ist, und falls dies der Fall ist, das andere Ende der Schnittkante verschoben wird.

5. Methode nach Anspruch 1, bei der, wenn das Medium mehrere Sprünge umfasst, die Sprünge innerhalb des regelmäßigen Vierecks berücksichtigt werden, wobei die folgenden Schritte ausgeführt werden:

   - Bestimmung einer ersten Kante des von der offenen Kurve geschnittenen Vierecks, wobei die Kurve Segment für Segment durchlaufen und von einem Ende der offenen Kurve ausgegangen wird;
   - Verschieben des Endes der am nächsten zum Schnittpunkt liegenden Kante zu dem Schnittpunkt, wenn diese Verschiebung nicht zu einem Viereck führt, bei dem mindestens ein Winkel größer als ein festgelegter Schwellenwinkel ist, und wenn dieses Ende nicht bereits verschoben wurde; anderenfalls
   - Verschieben des anderen Endes zu dem Schnittpunkt, wenn dieses Ende nicht bereits verschoben wurde; andernfalls

- Verfeinern des Netzwerks, bis ein Ende verschoben werden kann, und Verschieben dieses Endes.

6. Methode nach Anspruch 5, bei der das Netzwerk mit Hilfe der folgenden Schritte verfeinert wird:

- Hinzufügen eines neuen Knotens zu dem Netzwerk, entsprechend einem Schnittpunkt zwischen einem Bruch und der Kante, für die kein Ende verschoben werden kann;
- wenn die Kante vertikal ist, Verdoppeln der vollständigen Linie des Vierecks, umfassend den Schnittpunkt, wobei eine Aufeinanderfolge von horizontalen Kanten in allen Vierecken der Linie hinzugefügt wird, wobei die Aufeinanderfolge von Kanten durch den Schnittpunkt verläuft;
- wenn die Kante horizontal ist, Verdoppeln der vollständigen Spalte des Vierecks, umfassend den Schnittpunkt, wobei eine Aufeinanderfolge von vertikalen Kanten in allen Vierecken der Spalte hinzugefügt wird, wobei die Aufeinanderfolge von Kanten durch den Schnittpunkt verläuft.

7. Methode nach einem der vorhergehenden Ansprüche, bei der das regelmäßige Viereck in eine aus Vierecken zusammengesetzte Fläche mit drei Dimensionen umgeformt wird, wobei die folgenden Schritte durchgeführt werden:

- für jeden nicht auf einem Bruch befindlichen Knoten Bestimmung seiner Koordinaten anhand von baryzentrischen Koordinaten des Knotens in einem Bezugspunkt, der durch ein Dreieck der aus Dreiecken zusammengesetzten 2D-Fläche, dem er angehört, definiert ist;
- für jeden auf einem Bruch befindlichen Knoten Bestimmung seiner Koordinaten anhand von kurvigen Abszissen, die auf dem Bruch gemessen werden;
- Herstellung von Konnektivitäten zwischen den Knoten, um eine Anzahl von Vierecken zu maximieren, wobei nur Vierecke, für die ein Bruch durch eine ihrer Diagonalen verläuft, in zwei Dreiecke unterteilt werden.

8. Methode nach Anspruch 7, bei der Verbindungen zwischen den Knoten hergestellt werden, wobei jeder Knoten jeder dreidimensionalen, aus Vierecken zusammengesetzten Fläche mit denselben Koordinaten i, j verbunden wird, und wenn ein Bruch diese Verbindung schneidet, ein Konten mit dem Bruch verbunden wird, wobei eine Richtung eines benachbarten Knotens berücksichtigt wird.

**Claims**

1. A method of generating a mesh of an underground medium comprising at least one sedimentary layer traversed by at least one fault, said layer being vertically delimited by two geological horizons discretized by two triangulated three-dimensional surfaces, **characterized in that** it comprises:

- converting each triangulated three-dimensional surface to a triangulated two-dimensional surface onto which said fault is projected, by means of an isometric unfolding technique, the fault thus projected forming segments describing an open curve,
- generating a regular two-dimensional grid for each triangulated two-dimensional surface,
- deforming said regular two-dimensional grid by determining a first edge of said grid intersected by said open curve, by travelling along said curve segment by segment and starting from one end of said open curve; then by moving the end of the intersected edge closest to the intersection point towards said intersection point,
- performing a reference frame change so as to convert said regular grid thus deformed to a three-dimensional gridded surface and converting to two triangles each quadrilateral traversed by said fault at the level of a diagonal,
- reiterating the previous stages for the second triangulated three-dimensional surface while keeping the same number of quadrilaterals in each direction,
- generating said mesh of the underground medium by creating links between each node of each quadrilateral and each triangle of the two three-dimensional gridded surfaces, and by cutting each cell of said mesh of the underground medium traversed by said fault.

2. A method as claimed in claim 1, wherein said medium comprises more than one sedimentary layer, said mesh being constructed by reiterating layer by layer.

3. A method as claimed in claim 1, wherein said regular grid is generated by means of the following stages:

- selecting four points at the border of the two-dimensional surface, defining four curves at the border,
- selecting the dimensions of the grid (N, M) and alternately discretizing each one of the four curves according to said dimensions,
- applying Coons' formula to construct the grid.

4. A method as claimed in any one of the previous claims wherein, prior to moving said closest end, it is checked that this displacement does not generate a quadrilateral at least one angle of which is greater than a fixed angle threshold, and if so, the other end of the intersected edge is moved.

5. A method as claimed in claim 1, wherein said medium comprises several faults, the faults being taken into account within said regular grid by carrying out the following stages:

- determining a first edge of said grid intersected by said open curve by travelling along said curve segment by segment and starting from one end of said open curve,
- moving the end of the edge closest to the intersection point towards said intersection point if this displacement does not generate a quadrilateral at least one angle of which is greater than a fixed angle threshold, and if this end has not been moved yet ; if so,
- moving the other end towards said intersection point if this end has not been moved yet; if so,
- refining the mesh until one end can be moved, and moving this end.

6. A method as claimed in claim 5, wherein the mesh is refined by means of the following stages:

- adding a new node to the mesh, corresponding to an intersection point between a fault and the edge for which no end can be moved,
- if the edge is vertical, splitting the complete row of the grid containing the intersection point, by adding a succession of horizontal edges, in all the quadrilaterals of the row, the succession of edges passing through the intersection point,
- if the edge is horizontal, splitting the complete column of the grid containing the intersection point, by adding a succession of vertical edges, in all the quadrilaterals of the column, the succession of edges passing through the intersection point.

7. A method as claimed in any one of the previous claims, wherein said regular grid is converted to a three-dimensional gridded surface by carrying out the following stages:

- for each node that is not located on a fault, determining its coordinates from barycentric coordinates of the node in a reference frame defined by a triangle of the 2D triangulated surface to which it belongs,
- for each node located on a fault, determining its coordinates from curvilinear abscissas measured on said fault,
- establishing connectivities between the nodes so as to maximize a number of quadrilaterals, only quadrilaterals for which a fault passes through one of its diagonals are divided into two triangles.

8. A method as claimed in claim 7, wherein links are created between the nodes by linking each node of each three-dimensional gridded surface having the same coordinates i, j, and if a fault intersects this link, a node is linked to said fault by considering a direction of a neighbouring node.

**Fig. 1**

**Fig. 4**

Fig. 2

Fig. 3

**Fig. 5**

**Fig. 6**

**Fig. 7**

**Fig. 8**

**Fig. 9**

**Fig. 10**

Fig. 11

| Type 0 | Type 1 | Type 2 |

Fig. 12

Fig. 13

Fig. 14

Fig. 15

**Fig. 16**

**Fig. 17**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2747490

- US 5740342 A

**Littérature non-brevet citée dans la description**

- **Z.E. HEINEMANN ; G.F. HEINEMANN ; B.M. TRANTA.** Modelling heavily faulted reservoirs. *Proceedings of SPE Annual Technical Conferences,* Septembre 1998, 9-19

- **Z.E. HEINEMANN et al.** Modelling heavily faulted reservoirs. *Proceedings of SPE symposium on reservoir simulation,* 14 Février 1999, 9-19